# EUROPEAN PATENT SPECIFICATION

(11) **EP 0 959 495 B1**
(45) Date of publication and mention of the grant of the patent: **03.07.2013**
(21) Application number: 97946808.9
(22) Date of filing: 01.12.1997
(51) Int. Cl.: H01L 21/677

(54) **CONTAINER AND LOADER FOR SUBSTRATE**
BEHÄLTER UND LADEVORRICHTUNG FÜR SUBSTRATE
RECIPIENT ET CHARGEUR DE SUBSTRAT

(43) Date of publication of application: 24.11.1999
(73) Proprietor: Rorze Corporation, Hiroshima-ken 720-2104 (JP)
(72) Inventor: OHYAMA, Koji,, Tokyo 108 (JP); NAKAYAMA, Toshiya,, Minato-ku Tokyo 108 (JP); SAKIYA, Fumio Rorze Corporation, Fukayasu-gun Hiroshima-ken 720-21 (JP); KINPARA, Mineo Rorze Corporation, Fukayasu-gun Hiroshima-ken 720-21 (JP); FUJII, Toshiaki, Fujisawa-shi Kanagawa-ken 251 (JP); HORITA, Osamu, Fujisawa-shi Kanagawa-ken 251 (JP)
(74) Representative: Stenger, Watzke & Ring
(86) International application number: PCT/JP1997/004372
(87) International publication number: WO 1999/028965

(56) References cited:
- EP-A- 0 827 185
- JP-A- 5 003 240
- JP-A- 6 037 175
- JP-A- 9 306 975
- US-A- 4 797 054
- US-A- 5 664 925

## Description

### FIELD OF THE INVENTION

The present invention relates to a container and a loader for an article such as a substrate necessary to be kept under the condition of high cleanliness during being transported and worked, in particular the present invention relates to transporting means (hereinafter referred to as "loader") to transport the substrate or the like between the container used for transporting the substrate or the like through a low cleanliness room and a high cleanliness room for working the substrate or the like.

The present invention is applicable to any article necessary to be kept under the condition of high cleanliness during being transported and worked. It is described hereunder in relation to a semiconductor substrate such as a silicon wafer or a liquid crystal substrate, in particular a semiconductor wafer as an example, however, the present invention Is not limited to the above.

BACKGROUND OF THE INVENTION

The semiconductor substrate, in particular semiconductor wafer is contaminated when dust or vaporized organic compounds (hereinafter referred to as "dust") are attached thereto, thus leading to a lower productivity, i.e., the rate of producing a high-quality of product is low. It is therefore necessary to maintain high cleanliness in the surroundings of the substrate or the like when the semiconductor wafer is transported or worked. More specifically, the semiconductor wafer is one of the articles necessary to be kept under the condition of high cleanliness during transported and worked (hereinafter referred to as "dust free article").

In general, the semiconductor wafer is worked in a room where cleanliness is high (hereinafter referred to as a "high cleanliness room"), i.e., so called a clean room. On the other hand, when the semiconductor wafer is transported, the semiconductor wafer is received in an air-tightly sealed container, the inside of which is kept under the condition of high cleanliness (hereinafter referred to as a "container"), and then, the container with the semiconductor wafer received therein is transported. Thus, the semiconductor wafer can be transported through a room In which the degree of cleanliness is low or outdoor (hereinafter referred to as "low cleanliness room"), avoiding the semiconductor wafer from being contaminated during transported.

There is disposed a loader with an opening portion, which can be closed, in the border portion between the high cleanliness room and the low cleanliness room. The semiconductor wafer is transported through the above loader from the inner space of the container with high cleanliness for working the semiconductor wafer to the high cleanliness room (hereinafter referred to as "loading"), in addition, from the high cleanliness room to the inner space of the container with high cleanliness for transferring to an another treatment step (hereinafter referred to as "unloading"). More specifically, the semiconductor wafer is moved through the above opening portion. The container has a cover (i.e., lid) in a direction to the opening portion of the loader, which cover is opened when the semiconductor wafer is transferred.

When the semiconductor wafer is not transported, the opening portion of the loader is kept closed so as to prevent dust from floating into the high cleanliness room from the low cleanliness room. A door may be disposed in the opening portion so that

the opening portion can be opened or closed by the door. In this case, the door may be large enough to completely close the opening portion. In addition, the door may be the size in which the door is about 5 mm smaller in each side than respective side of the opening portion in such manner that there is provided aperture (open space) between the door and the opening portion, while the air pressure in the high cleanliness room is kept higher than that in the lower cleanliness room, thus air flows through the aperture from the high cleanliness room to the low cleanliness room.

The following standards for the above container and loader are proposed and applied: SEMI (Semiconductor Equipment and Material International) Standard E47.1 [Box/Pod (FOUP)], E15.1[Tool Load Port], E57[Kinematic Coupling], E62[Front-Opening Interface Standard (FIMS), E63 [Box/Opener to Tool Standard (BOLTS) and the like (hereinafter referred to as "Standard").

### PRIOR ART

The semiconductor wafer is transported through the opening portion between the container with the door opened and the high cleanliness room. However, as described above, it is essential to consider that the semiconductor wafer is not contaminated by dust. It is therefore necessary to note that the dust floating in the low cleanliness room, the dust attached to the container, particularly, the cover of the container, the dust attached to the door of the loader in the side of the lower cleanliness room or the dust generated along with the driving of the loader has to be prevented from floating into the high cleanliness room.

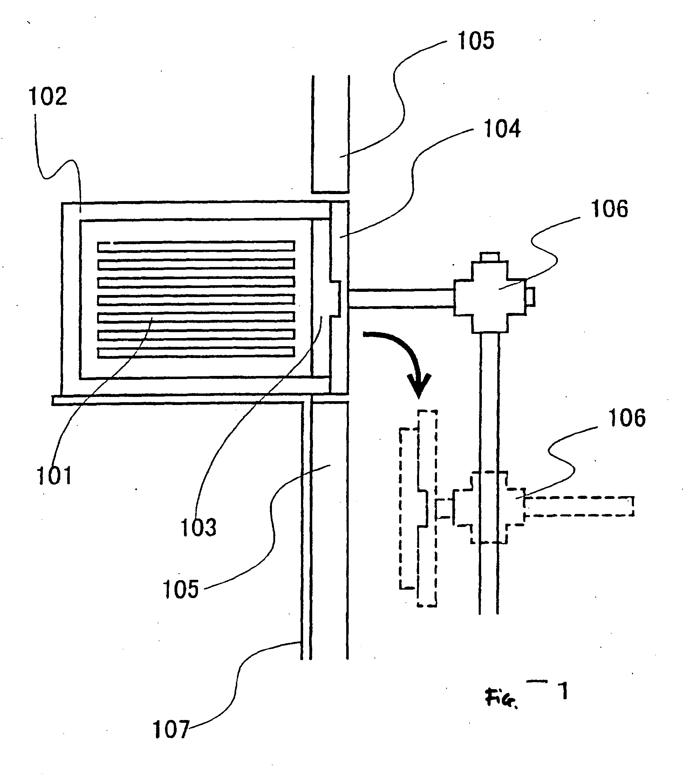

As one of the methods to realize the above requirement to prevent the dust from floating into the high cleanliness room, there is disclosed the method in German Patent Application No. 19511024-2 (filed on March 28, 1995), German Patent Application No. 19542646-2 (filed on November 15, 1995), and Japanese Patent Provisional Publication No. 8-279546. The method is described hereinbelow with reference to Fig. 1.

A wall 105 separates a high cleanliness room in the right hand side in the drawing from a low cleanliness room in the left hand side in the drawing. An opening portion of the wall 105 is closed by the door 104 of a loader. A semiconductor wafer 101 is received inside of a container 102, and dust is prevented from floating into the container by a cover 103. The semiconductor wafer is transferred from the inside of the container to the high cleanliness room in the drawing as follows:
(1) The container 102 is mounted on a stage 107 of the loader;
(2) The cover 103 of the container 102 is fixed onto the door 104 of the loader so as to be unified;
(3) Thus fix-unified cover 103 and door 104 is pulled out in a horizontal direction by a driving apparatus disposed in the high cleanliness room, and then lowered vertically to be moved eventually to the position illustrated with a dotted line in the drawing;
(4) The container 102 and the opening portion of the wall 105 are fully opened;
(5) The semiconductor wafer 101 is transferred to the high cleanliness room; and
(6) The semiconductor wafer 101 is worked in the high cleanliness room.

In the above method, however, since the cover 103 and the door 104 of the loader are moved into the high cleanliness room, the dust attached thereto is also moved and scattered into the high cleanliness room. Although it is described in the above disclosure that the dust is fixed within a portion tightly hold between the cover 103 and the door 104 in such manner that the dust is not scattered in the high cleanliness room, it is difficult to completely fix the dust so as not to be scattered. It is therefore difficult to prevent the dust from being scattered.

In addition, since the driving apparatus 106 for moving the cover 13 and the door 104 to the high cleanliness room is required to be disposed in the high cleanliness room, the driving apparatus 106 generates dust in the high cleanliness room. When movable portions in the driving apparatus such as a motor or a cylinder are operated, dust is generated by friction of the portions. Furthermore, lubricants applied to the movable portions are evaporated to be scattered in the high cleanliness room, thus it is impossible to keep high cleanliness therein.

Furthermore, since the cover 103 and the door 104 are moved in a horizontal direction by the driving apparatus 106, and then lowered in a vertical direction, the driving apparatus 106 is required to drive the cover and the door in two directions, thus the apparatus becomes in such complex construction that the accuracy of the operation of the apparatus is apt to be lowered and at the same time the cost of the apparatus increases. Furthermore, the time required for one cycle of the operation increases to lead the product efficiency to be poor.

Furthermore, the dust is inevitably generated when the driving apparatus is kept operable, controlled and repaired. Since the driving apparatus is disposed in the high cleanliness room, the dust is scattered in the high cleanliness room. In addition, when a worker carries out workings in the high cleanliness room, it is required to install an equipment to remove the dust attached to the body of the worker, thus increasing the cost.

The present invention has been made to solve the above problem in the prior art. The object of the invention is therefore to provide a container and a loader for semiconductors by which a semiconductor wafer is received in a container and transported in a low cleanliness room, the semiconductor wafer is worked in a high cleanliness room , and the semiconductor wafer is transported between the container and high cleanliness room without causing dust to float into the high cleanliness room from the low cleanliness room, and generating dust in the high cleanliness room and with easy maintenance, control and repair of the apparatus.

US 5,664,925 discloses a batchloader for batch loading semiconductor wafers into a load lock from a portable carrier. A load lock chamber is closed by a load lock door in such a manner that the load lock door is held firmly against a suitable seal interposed between the load lock door and the load lock.

### SUMMARY OF THE INVENTION

In order to attain the above object, there is provided a following invention.

There is provided a loader for transporting a dust free article, wherein the loader is disposed in a low cleanliness room in a border between the low cleanliness room and a high cleanliness room having higher pressure than the low cleanliness room, the loader comprising:
a) a movable stage positioned in the low cleanliness room for mounting a container in such manner that the entire container remains in the low cleanliness room, and a cover to be removed from a main body of the container positioned to face the high cleanliness room, the movable stage being horizontally movable relative to a wall that separates the low cleanliness room from the high cleanliness room;
b) an opening portion in the wall through which a dust free article is transported between an inside of the container and the high cleanliness room;
c) a door for opening the opening portion,
d) an unifying means for unifying the cover of the container and the door in the low cleanliness room;
e) a driving apparatus positioned in the low cleanliness room for moving the cover and the door together within the loader such that the opening portion and the container can be opened simultaneously; and characterized in that
f) a gap is provided between the opening portion and the door through which air flows out from the high cleanliness room to the low cleanliness room to prevent dust flowing into the high cleanliness room.

According to the invention, there can be provided a loader in which dust does not float into the high cleanliness room when the dust free article is transported between the inside of the container and the high cleanliness room.

There is provided an embodiment, which is a loader, wherein a direction of moving unified said cover and said door within said loader is vertical.

According to the invention, there can be provided a loader in which the bottom area of the loader is made smaller, thus improving efficiency in installing area.

There is provided an embodiment, which is a loader, wherein a direction of causing said container mounted on said stage to approach said door is horizontal.

According to the invention, it is possible to stably move the container on the loader.

There is provided an embodiment, which is a loader, wherein said unifying means for unifying said cover and said door comprises:
(a) a pin for being inserted in a hole formed in a protrusion arranged on outside of said cover;
(b) another pin for being inserted in another hole formed in said door; and
(c) a driving apparatus for simultaneously moving both of said pin and said another pin to unify said cover and said door.

According to the invention, the dust generated by the unifying means can be prevented from floating into the container, since the unifying means is located outside of the container.

There is provided an embodiment, which is a loader, which further comprises a driving apparatus for causing said container mounted on said stage to approach to said door.

According to the invention, the container can be automatically moved on the loader.

There is provided an embodiment, which is an apparatus comprising a loader and a container for receiving a dust free article therein and transporting said dust free article, enabling to be mounted on a loader which includes an opening portion disposed in a side of a low cleanliness room in a border portion between a high cleanliness room and said low cleanliness room, and a door for opening and closing said opening portion, which comprises:
(a) an opening port through which said dust free article is transported between an inside of said container and said high cleanliness room;
(b) a cover which enables to cover said opening port, is unified with the door of said loader and is moved within said loader to open and close said opening portion;
(c) fixing means for fixing said cover to said opening port when said dust free article is received in said container and is transported.

According to the Invention, there can be provided an apparatus which prevents the dust from floating into the high cleanliness room when the dust free article is transported between the inside of the container and the high cleanliness room.

There is provided an embodiment, which is an apparatus, wherein a direction of said cover unified with the door of said loader and moved within said loader is vertical.

According to the invention, there can be provided a loader in which the bottom area of the loader is made smaller, thus improving efficiency in installing area.

There is provided an embodiment, which is an apparatus, wherein an angle formed by a outward normal line on a surface on which said opening port is closely contacted with said cover and a descending direction of said cover unified with the door of said loader and vertically moved within said loader is an acute angle.

According to the invention, it is possible to prevent the dust from being generated by lowering a friction between the contacting surfaces of the opening portion and the cover.

There is provided an embodiment, which is an apparatus, which further comprises a sealing material for closing a gap between both of said cover and said opening port.

According to the invention, it is possible to prevent the dust from floating into the container.

There is provided an embodiment, which is an apparatus, which further comprises positioning means to position said container in relation to said loader when said container Is mounted on said loader.

According to the invention, the container can be securely mounted on the loader.

There is provided an embodiment, which is an apparatus, which further comprises a handle to support said container when said container is transported.

According to the invention, the container can be easily transported by a human being or robot.

There is provided an embodiment, which is an apparatus, which further comprises a protrusion formed on outer portion of said cover, which has a hole to which a pin is inserted for unifying said cover and the door of said loader.

According to the invention, the dust generated by the transfer mechanism of the pin or friction between the pin and the protrusion can be prevented from floating into the inside of the container, since the protrusion for unifying is located outside of the container.

There is provided an embodiment, which is an apparatus for transporting a dust free article, wherein a direction of said cover unified with the door of said loader and moved within said loader is vertical.

According to the invention, it is possible to make bottom area of the loader smaller, thus improving efficiency in installing area.

There is provided an embodiment, which is an apparatus for transporting a dust free article, wherein said loader further comprises a driving means for causing said container mounted on said stage to approach said door.

According to the invention, there can be provided an apparatus which enable to automatically move the container on the loader.

There is provided an embodiment, which is a method for transporting a dust free article according to claim 12.

According to the invention, there can be provided a method for transporting a dust free article which can be prevented the dust from floating into the high cleanliness room when transporting the dust free article between the inside of the container and the high cleanliness room.

There is provided an embodiment, which is a method for transporting a dust free article, which further comprises steps of:
(a1) fixing said container mounted on said stage to said stage to unify said container and said stage in step (a); and
(b1) moving said stage by a driving apparatus included in said loader to cause said container to approach the door of said loader in step (b).

According to the invention, there can be provided a method for enabling to automatically move the container on the loader.

There is provided an embodiment, which is a method for transporting a dust free article, wherein a direction of said cover unified with the door of said loader and moved within said loader is vertical.

According to the invention, it is possible to make smaller the bottom area of the installation used in the transporting method, thus improving efficiency in installing area.

### BRIEF DESCRIPTION OF THE DRAWINGS

Fig. 1 is a conceptional view illustrating an embodiment of the prior art in which a sectional view of the container and loader is shown.
Fig. 2 is a conceptional view illustrating an embodiment of the present invention in which a sectional view of the container and loader of the invention is shown.
Fig. 3 is a conceptional view illustrating an embodiment of the present invention In which a sectional view of the container and loader of the invention is shown.
Fig.4 is a descriptive view illustrating an example of the container of the invention.
Fig. 5 is a descriptive view illustrating multiple of examples of the container of the invention.
Fig. 6 is a descriptive view illustrating an example of the loader of the invention.
Fig. 7 is a descriptive view illustrating an example when multiple loader are installed in the invention.
Fig. 8 is a descriptive view illustrating an example of unifying means for unifying the door of the loader and the cover of the container of the invention.

### DETAILED DESCRIPTION OF PREFERRED EMBODIMENTS

The best mode of the embodiments of the invention is described hereinbelow. The following embodiments do not limit the scope of the invention. Skilled person in the field can therefore execute other embodiments within a scope of the invention.

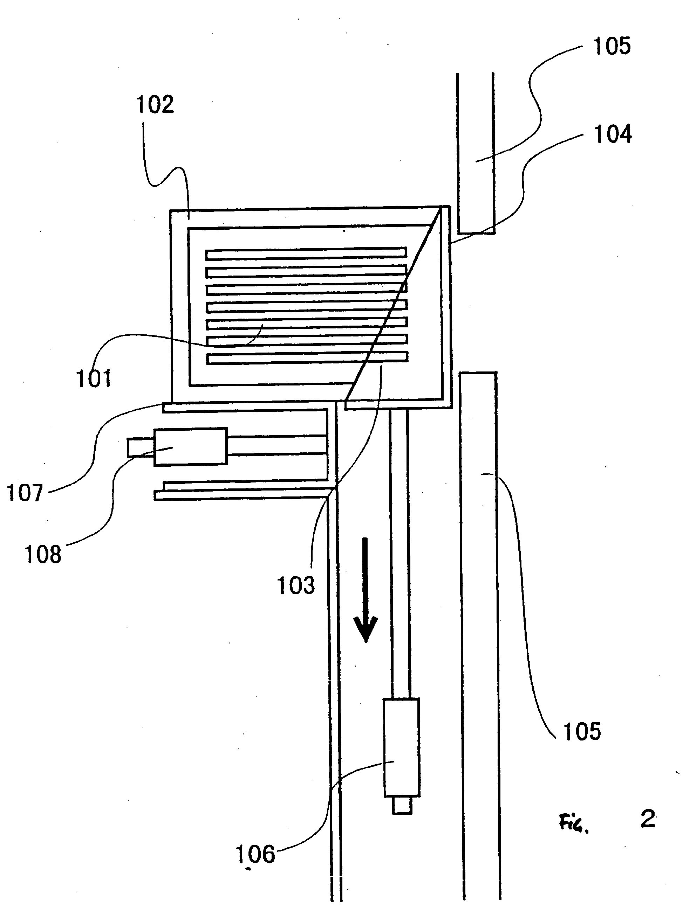

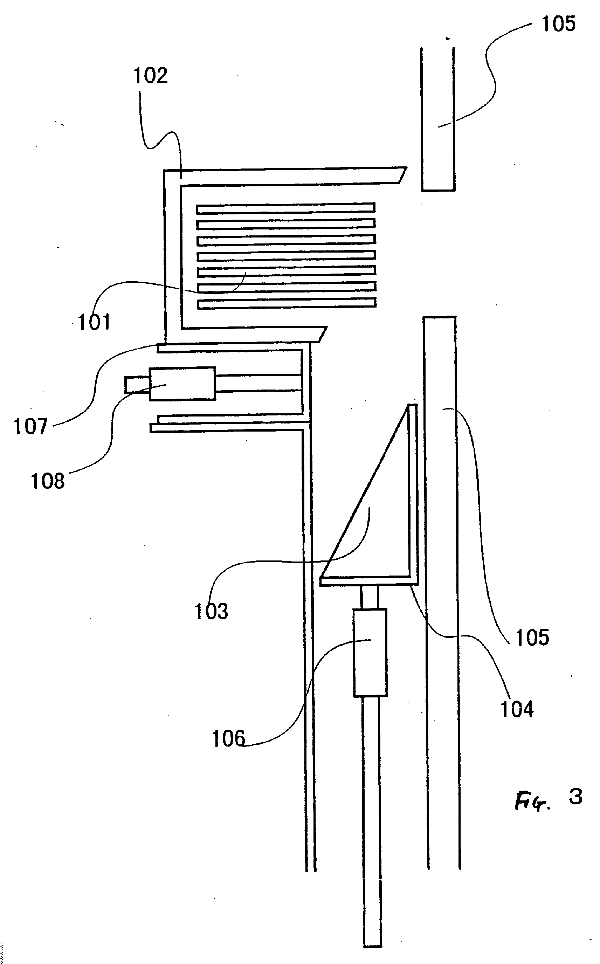

Figs. 2 and 3 are schematic descriptive view illustrating the container and loader of the invention. In Fig. 2, the high cleanliness room in the right side is separated from the low cleanliness room in the left side by the wall 105. There is arranged an opening portion in the wall 105, which opening portion is usually closed by the door 104 of the loader (this situation is out of the scope of the invention). Alternatively, as described above and according to the present invention, a gap is provided between the door 104 and the opening portion, and the air pressure of the high cleanliness room is controlled so as to be higher than the air pressure of the low cleanliness room, thus causing air to flow from the high cleanliness room to the low cleanliness room to prevent the dust from floating into the high cleanliness room.

The semiconductor wafer is received inside of the container 102, and the container is air-tightly closed. Under this condition, the inside of the container 102 is kept in high cleanliness. Accordingly, when container 102 is transported through the low cleanliness room, the semiconductor wafer 101 in the container is never contaminated.

The process for transporting a semiconductor wafer from the container to the high cleanliness room in the present invention is described hereinbelow.

Firstly, the container 102 is mounted on the stage 107 of the loader. The container 102 may be mounted by the hands of human being, or may be transported by the transporting robot installed in the ceiling or the robot mounted on the AGV running on the floor. For this purpose, a flange may be arranged on the upper portion of the container 102. The above-mentioned transportation may be carried out by the use of the process defined in the standard, for example.

Then, the container 102 is fixed onto the stage 107 in such manner that the container and the stage are unified. The above-mentioned unification is carried out in the predetermined location. For this purpose, the positioning mechanism such as Kinematic Coupling defined in the standard may be disposed. As the method for unifying the container 102 and the stage 107, and positioning, the methods defined in the standard may be applied.

Then, the stage 107 is moved in the direction to the opening portion of the wall 105 to cause the cover 103 to approach the door 104 of the loader. The stage 107 may be moved by the driving mechanism 108. However, there is included the embodiment without the driving mechanism 108 for the stage 107. In this case, when bearings, wheels, rollers and the like, for example, are disposed on the stage to smoothly move the stage in the horizontal direction, the container mounted on the stage may be caused to approach the door 104 by human power. The driving mechanism 108 of the stage 107 is described later.

Then, the cover 103 and the door 104 of the loader are unified. This unification of the cover and the door may be executed by the use of the conventional methods such as a clamp mechanism or frictional means. Embodiments of the unification of the cover and the door are described later.

While the cover 103 is kept fixed to the door 104, the stage 107 is moved backward slightly, thus the cover 103 Is removed from the container 102. The above-mentioned moving (driving) mechanism of the stage 107 may be used as it is for the above backward movement. The means to close or open the container by the cover are described later.

Furthermore, the cover 103 together with the door 104 are moved downward by the driving mechanism 106. Thus, the container 102 is opened toward the high cleanliness room. Fig. 3 shows that the container is opened toward the high cleanliness room. In this situation, since the air flows from the high cleanliness room to the low cleanliness room, the dust can be prevented from floating into the high cleanliness room.

Finally, the semiconductor wafer 101 is transported from the inside of the opened container to the high cleanliness room and worked therein. After being worked, the semiconductor wafer 101 may be returned to the same container 102, or received in another container through another opening portion. As the means to transport the semiconductor wafer received in the container between the container and the high cleanliness room, the known means such as a robot arm for transporting, for example, a scalar type robot for clean room may be used. The detailed description thereof are omitted here.

After finishing working, when reverse processes are carried out, the semiconductor wafer 101 can be transported from the high cleanliness room to the container 102 while high cleanliness is kept. Then, when the container 102 is air-tightly closed by the cover 103, the semiconductor wafer can be transported through the low cleanliness room.

In the present invention, when the container is not mounted on the stage 107, the opening portion of the wall 105 is closed by the door 104, thus the dust is prevented from floating into the high cleanliness room from the low cleanliness room. Accordingly, high cleanliness can be maintained in the high cleanliness room.

Furthermore, in the present invention, the cover 103 is unified to the door 104, and thus unified cover and door is moved downward in the low cleanliness room to open both of the opening port of the container and the opening portion of the wall 105. More specifically, since the driving mechanism 106 for driving the cover 103 and the door 104 is located in the low cleanliness room, the dust generated by the driving mechanism 106 does not float into the high cleanliness room. Furthermore, the maintenance, control and repair of the driving mechanism 106 are carried out in the low cleanliness room, thus lowering the required cost thereof.

According to the conventional means, since a single driving mechanism moves the container in both of the horizontal and vertical directions, the driving mechanism becomes complex and the cost thereof increases. In addition, there is a problem in which accuracy of the operation in the driving mechanism is lowered. Contrary to the conventional driving mechanism, in the present invention, the driving mechanism 106 moves the apparatus in the vertical direction, and the stage driving mechanism 108 moves the apparatus in the horizontal direction. More specifically, since each driving mechanism moves the apparatus in only one direction, driving mechanisms comprising simple elements can be applied, thus improving accuracy of the operation and lowering the required cost thereof.

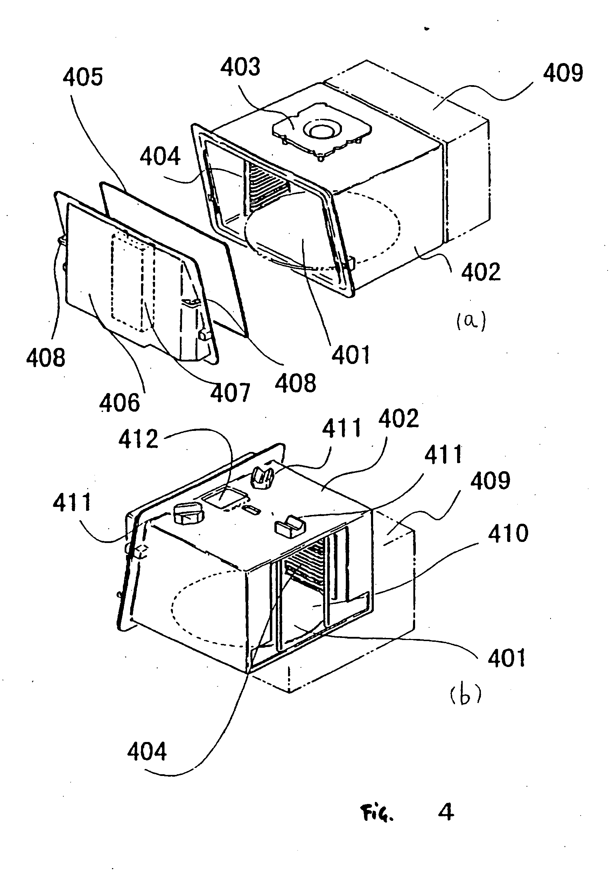

Now, the best embodiment of the container of the invention is described with reference to Figs. 4(a) and 4(b).

In Fig. 4(a), teeth portion 404 is disposed inside of the container 402 to hold the semiconductor wafer 401. The teeth portion 404 can hold a plurality of semiconductor wafers 401.

A flange 403 is disposed on the upper portion of the container 402. The container 402 is automatically moved by the transporting robot installed in the ceiling with the use of the flange. The shape of the flange 403 is about square, each side of which square has different numbers and shapes of rifts. The contact sensor or the like identifies the direction to which the container faces by means of the rifts. It is preferable to apply the flange, the shape of which is defined in the standard.

The container 402 and the cover 406 are air-tightly sealed by means of an O-ring 405 comprising elastic body . The O-ring 405 may be fixed either to the cover 406 or the container 402.

A wafer pressing device 407 comprising elastic body is disposed on the cover 406 in order to prevent the semiconductor wafer 401 from moving or swinging inside of the container when the container is transported. The hole 408 disposed on the cover 406 is disposed so as to receive the pin which unifies the cover and the door of the loader. The mechanism to unify the cover and the door is described later.

In Fig. 4(b), Kinematic Coupling 411 is disposed on the bottom surface of the container 402. The relative positioning of both of the stage of the loader and the container 402 is carried out by means of the Kinematic Coupling 411. The recess 412 used for clamp mechanism to fix the container 402 to the stage so as to unify the container and the stage. The shape, size and location are preferably in accordance with the standard.

Another opening port, which is different from the opening port of the container located front side thereof, may be disposed in the rear portion of the container 402. In the opening port 410, there can be disposed a air cleaning device 409, for example a fan, which exhausts the air inside of the container 402 to clean the air. However, the above-mentioned another opening port may not be disposed, and the air cleaning device may also not be disposed. In the rear portion of the inside of the container, there may be disposed same wafer pressing device (not shown) as the wafer pressing device 407 disposed on the cover 406 so as to prevent the semiconductor wafer 401 from being damaged.

The cover 406 and the container 402 are air-tightly sealed by means of the O-ring, as described above. In order to more securely seal the cover and the container, there may be disposed a magnet or an adhesive tape on each of the surfaces with which the cover 406 and the container are contacted. Furthermore, there may be disposed a clamp mechanism (not shown) to fix the cover 406 onto the container 402 in such manner that the cover is not removed from the container when the container is transported.

The angle formed by the outward normal line on the surface on which the opening port of the container 402 is contacted with the cover 406, and a descending direction of the cover unified with the door of the loader is up to 90 degrees. With the above angle to be up to 90 degrees, when the cover 406 unified with the door are moved, the container 402 does not disturb the movement of the unified cover and the door.

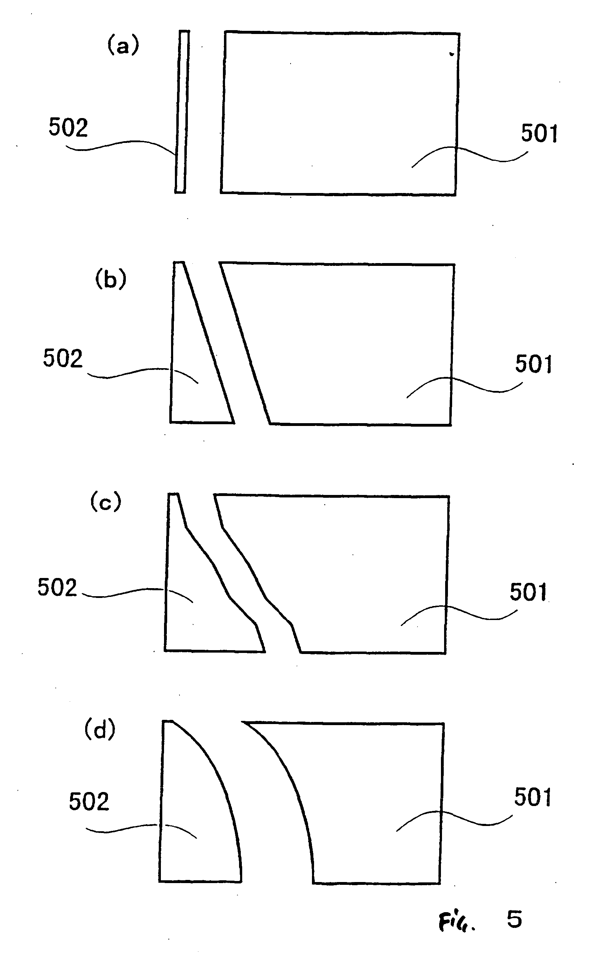

Figs. 5(a) to 5(d) show various schematic side views of the cover and the container. Fig. 5(a) shows the example in which the angle formed by the outward normal line on the surface on which the opening port of the container 501 is contacted with the cover 502, and a descending direction of the cover unified with the door of the loader is 90 degrees. Fig. 5(b) shows the example in which the angle is about 72 which is not changed. Fig. 5(c) shows the example in which the angle is changed step by step. Fig. 5(d) shows the example in which the angle is changed continuously. Those are the examples in which the angle is positive.

With the above angle to be excessively small, the area of the wall surface and the bottom surface of the container 501 becomes small, thus lowering the (sitting) stability of the container 501. On the other hand, with the angle to be excessively large, the friction between the container 501 or the cover 502 and the elastic O-ring is generated to produce the dust when the cover 502 is moved.

In the present invention, there may be the embodiment in which the container is mounted on the loader, then after the cover and the door are unified, the container is slightly moved backward in the horizontal direction to remove the cover from the main body of the container. In this case, since the gap is produced between the container and the cover, the above-mentioned friction is not generated. Accordingly, it is possible to set the above angle so as to be within the scope from 70 to 90 degrees.

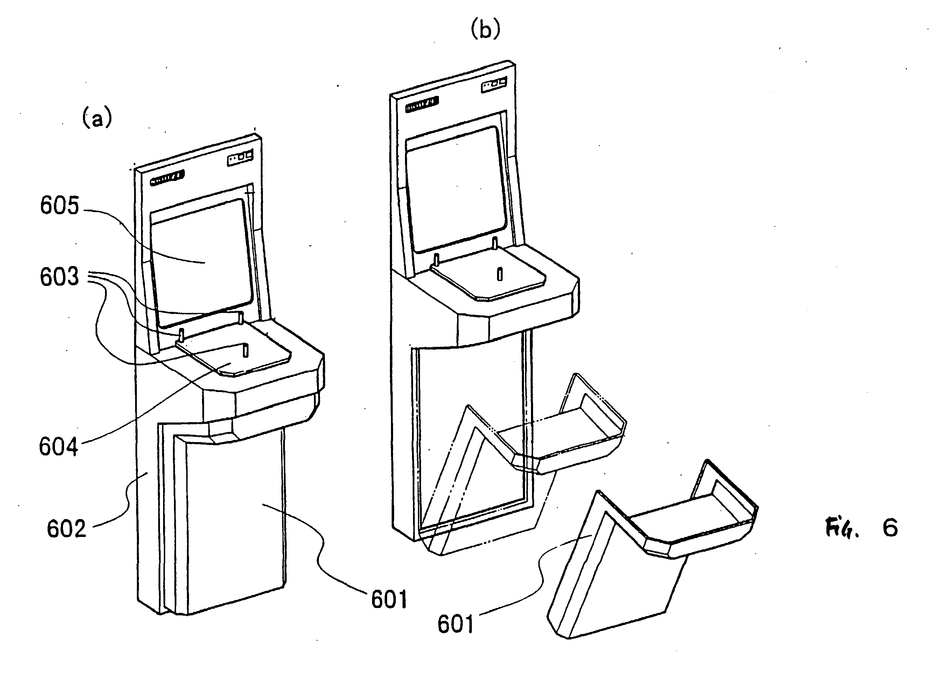

In Figs. 2 and 3, as described above, the inner mechanism of the loader is briefly described. Fig. 6 shows outward appearance of one of the embodiments of the loader of the invention.

The driving means of the loader is covered by the front cover 601 and the driving means cover 602. The maintenance, inspection and repair of the driving means is easily carried out by pulling the front cover 601 outward (to the frontal direction). The loader as a whole is installed in the low cleanliness room, and the above-mentioned maintenance and the like can be carried out in the low cleanliness room.

On the stage 604 of the loader, there are disposed pins of kinematic coupling which correspond to the V shaped groove of the kinematic coupling of such standard as formed on the bottom portion of the container, which carry out the positioning of the container. The opening portion 605 of the loader is closed by the door when the container is not mounted, and when the container is mounted the door descends downward in such manner that the semiconductor wafer can be transported between the container and the high cleanliness room.

When the air pressure in the high cleanliness room is caused to be kept higher than the air pressure in the low cleanliness room, the dust can be prevented from floating into the high cleanliness room. Furthermore, for example, when the fan for exhausting is disposed in the lower portion of the cover 602, the air flow from the high cleanliness room to the low cleanliness room is assisted or accelerated. Accordingly, even if the dust generated by the operational friction of the mechanical parts inside of the loader, or the organic compound produced by the evaporation of the lubricant is scattered, the dust or organic compound can be effectively prevented from floating into the high cleanliness room. The degree of the cleanliness of the high cleanliness room in the invention can be therefore kept higher than that of the conventional apparatus and method.

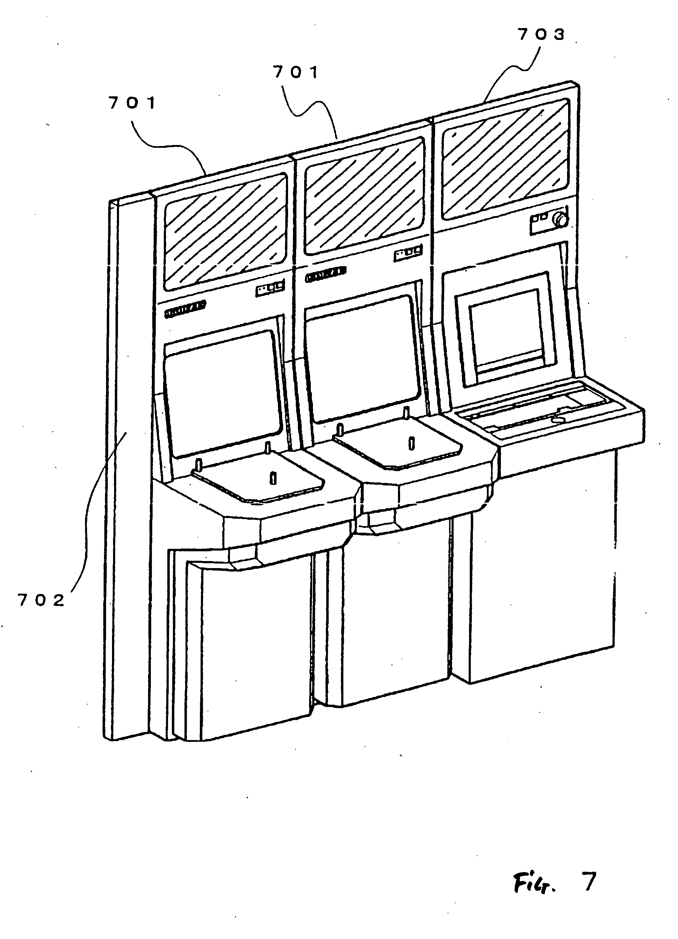

The moving direction of the unified cover and door is not necessarily limited to upward and downward along the vertical direction. The above-mentioned effect can be obtained as far as the unified cover and door moves within the loader installed in the low cleanliness room. However, when the moving direction is selected so as to be the vertical or about vertical direction, it is possible to arrange the loader of the invention side by side in the lateral direction, as shown in Fig. 7.

Fig. 7 shows the example in which two loaders 701 and the control board 703 are arranged on the wall 702. According to this arrangement, for example, one loader is restricted to solely carry in the semiconductor wafer, and the other loader is restricted to solely carry out the semiconductor wafer, thus enabling to transport and work the semiconductor wafer in sequential operation. Furthermore, since the bottom area of the loader itself is relatively small, the area is efficiently used when the loaders are installed in the factory.

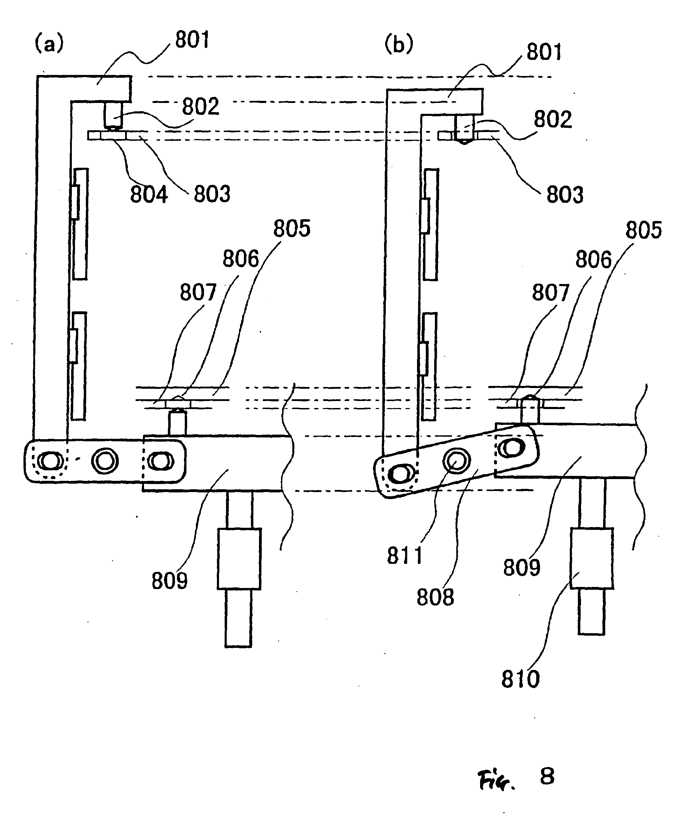

Fig. 8 shows one example of the means to unify the cover and the door. There is disposed the protrusion 803 having the hole 804 on the outer portion of the cover of the container, and there is disposed a hole on the bottom portion 807 of the door of the loader. In addition, there is disposed the recess 806 on the bottom portion 805 of the cover which corresponds to the hole of the bottom portion 807 of the door of the loader. The unifying mechanism for unifying the cover and the door is disposed in the loader. The driving mechanism 810 is caused to take such rectilinear motion that the rotary lever 808 is caused to rotate around the axis 811. As a result, the bar 801 descends, and the pin located at the tip portion thereof thrusts the hole 804 of the protrusion 803 on the cover of the container. At the same time, the supporter 809 ascends, and the pin located at the tip portion thereof thrusts the hole of the bottom portion 807 of the door and is received in the recess 806 of the bottom portion 805 of the cover. As described above, according to an embodiment of the present invention, by preparing such a simple rectilinear motion mechanism 810, rotary lever 811, and the bar 801 and supporter 809, it is possible to provide the unifying mechanism of the door and the cover with a low cost.

In the conventional art, since the lock mechanism to unify the cover and the door is installed inside of the container, when the cover and the door are opened, the dust generated by the lock mechanism may floats into the inside of the container by the air flow of the high cleanliness room, thus contaminating the inside of the container. On the contrary, in an embodiment of the present invention, since the lock mechanism can be installed outside of the container, the inside of the container is never contaminated.

As described above, according to the invention, the semiconductor wafer can be effectively prevented from being contaminated by the dust even when the container is transported through the low cleanliness room, since the semiconductor wafer is received and transported by the sealed container. When the semiconductor is to be worked, the cover of the container and the door of the loader are unified, and thus unified cover and door descends in the low cleanliness room, thus the container and the high cleanliness room are opened and the semiconductor wafer is transported between the container and the high cleanliness room. Since all the mechanical elements to generate the dust are disposed in the low cleanliness room side, it is possible to keep high degree of high cleanliness in the high cleanliness room.

The present invention can be applied not only to the working of the semiconductor, but also to the container and the loader for the articles other than the semiconductor which require high cleanliness in the working thereof.

## Claims

1. A loader for transporting a dust free article, wherein the loader is disposed in a low cleanliness room in a border between the low cleanliness room and a high cleanliness room having higher pressure than the low cleanliness room, the loader comprising:
a) a movable stage (107) positioned in the low cleanliness room for mounting a container (102, 402) in such manner that the entire container remains in the low cleanliness room, and a cover (103, 406) to be removed from a main body of the container positioned to face the high cleanliness room, the movable stage being horizontally movable relative to a wall (105) that separates the low cleanliness room from the high cleanliness room;
b) an opening portion (605) in the wall (105) through which a dust free article can be transported between an inside of the container and the high cleanliness room;
c) a door (104) for opening the opening portion;
d) an unifying means for unifying the cover of the container and the door in the low cleanliness room;
e) a driving apparatus (106) positioned in the low cleanliness room for moving the cover and the door together within the loader such that the opening portion and the container can be opened simultaneously; and **characterized in that**
f) a gap is provided between the opening portion and the door through which air flows out from the high cleanliness room to the low cleanliness room to prevent dust flowing into the high cleanliness room.

2. The loader for transporting a dust free article as claimed In claim 1, wherein a direction of said cover unified with the door of said loader and moved within said loader is vertical.

3. The loader for transporting a dust free article as claimed in claim 1, wherein said loader further comprises a driving portion for causing a container mounted on said stage to approach said door.

4. The loader as claimed in claim 1, wherein said unifying means for unifying said cover and said door comprises:
a) a pin for being inserted in a hole formed in a protrusion arranged on outside of said cover;
b) another pin for being inserted in another hole formed in said door, and
c) a driving apparatus for simultaneously moving both of said pin and said another pin to unify said cover and said door.

5. The loader as claimed in claim 1, which further comprises a driving apparatus for causing a container mounted on said stage to approach to said door.

6. An apparatus comprising the loader of claim 1 and a container (102, 402) for receiving a dust free article therein and transporting said dust free article, said container being mountable on the loader, the container comprising:
a) an opening port through which said dust free article can be transported between an inside of said container and said high cleanliness room;
b) a cover (406) which enables to cover said opening port, configured for being unified with the door(104) of said loader and for being moved within said loader to open and close said opening portion;
c) fixing means for fixing said cover to said opening port when said dust free article is received in said container and is transported.

7. The apparatus as claimed in claim 6, wherein an angle formed by an outward normal line on a surface on which said opening port is dosely contacted with said cover and a descending direction of said cover unified with the door of said loader and vertically moved within said loader is an acute angle.

8. The apparatus as claimed in claim 6, which further comprises a sealing material for closing a gap between both of said cover and said opening port.

9. The apparatus as claimed in claim 6, which further comprises positioning means to position said container in relation to said loader when said container is mounted on said loader.

10. The apparatus as claimed in claim 6, which further comprises a handle to support said container when said container is transported.

11. The apparatus as claimed in claim 6, which further comprises a protrusion formed on outer portion of said cover, which has a hole to which a pin can be inserted for unifying said cover and the door of said loader.

12. A method for transporting a dust free article using the apparatus of claim 6, which comprises the steps of:
a) mounting the container receiving said dust free article on the stage disposed on said loader,
b) causing said container to approach the door of said loader,
c) unifying the cover of said container and the door of said loader,
d) simultaneously moving thus unified cover and door within said loader to simultaneously open the opening port of said loader and said container; and
e) transferring said dust free article received in said container from an inside of said container to said high cleanliness room through the opening portion of said loader.

13. The method for transporting a dust free article as claimed in claim 12, which further comprises steps of:
a1) fixing said container mounted on said stage to said stage to unify said container and said stage in step a); and
b1) moving said stage by a driving apparatus included in said loader to cause said container to approach the door of said loader in step b).

14. The method for transporting a dust free article as claimed in claim 12, wherein a direction of said cover unified with the door of said loader and moved within said loader is vertical.

## Patentansprüche

1. Ladevorrichtung zum Transport eines staubfreien Gegenstandes, wobei die Ladevorrichtung in einem Niedrigreinheitsraum an einer Grenze zwischen dem Niedrigreinheitsraum und einem Hochreinheitsraum mit höherem Druck als der Niedrigreinheitsraum angeordnet ist, wobei die Ladevorrichtung aufweist:
a) eine bewegliche Bühne (107), die in dem Niedrigreinheitsraum angeordnet ist, um einen Behälter (102, 402) derart anzubringen, dass der gesamte Behälter in dem Niedrigreinheitsraum verbleibt, und einen Deckel (103, 406), der von einem Hauptkörper des Behälters zu entfernen ist, welcher zu dem Hochreinheitsraum hingewandt angeordnet ist, wobei die bewegliche Bühne gegenüber einer Wand (105), welche den Niedrigreinheitsraum von dem Hochreinheitsraum trennt, horizontal beweglich ist;
b) einen Öffnungsbereich (605) in der Wand (105), durch welchen ein staubfreier Gegenstand zwischen einem Innenraum des Behälters und dem Hochreinheitsraum transportiert werden kann;
c) eine Tür (104) zum Öffnen des Öffnungsbereiches;
d) einer Vereinigungsvorrichtung zum Vereinigen des Deckels des Behälters mit der Tür in dem Niedrigreinheitsraum;
e) ein Antriebsgerät (106), das in dem Niedrigreinheitsraum angeordnet ist, um den Deckel und die Tür zusammen innerhalb der Ladevorrichtung derart zu bewegen, dass der Öffnungsbereich und der Behälter gleichzeitig geöffnet werden können; und
**dadurch gekennzeichnet, dass**
f) ein Spalt zwischen dem Öffnungsbereich und der Tür vorgesehen ist, durch welchen Luft aus dem Hochreinheitsraum in den Niedrigreinheitsraum strömt, um zu verhindern, dass Staub in den Hochreinheitsraum gelangt.

2. Ladevorrichtung zum Transport eines staubfreien Gegenstandes gemäß Anspruch 1, wobei eine Ausrichtung des mit der Tür der Ladevorrichtung vereinigten und innerhalb dieser Ladevorrichtung bewegten Deckels vertikal ist.

3. Ladevorrichtung zum Transport eines staubfreien Gegenstandes gemäß Anspruch 1, wobei die Ladevorrichtung ferner einen Antriebsbereich aufweist, um zu bewirken, dass ein auf der Bühne befestigter Behälter nahe an die Tür gebracht wird.

4. Ladevorrichtung gemäß Anspruch 1, wobei die Vereinigungsvorrichtung zum Vereinigen des Deckels mit der Tür aufweist:
a) einen Stift zum Einführen in ein Loch, das in einem an der Außenseite des Deckels angeordneten Vorsprung ausgebildet ist;
b) einen weiteren Stift zum Einführen in ein weiteres, in der Tür ausgebildetes Loch; und
c) ein Antriebsgerät, um sowohl den einen Stift als auch den anderen Stift gleichzeitig zu bewegen zur Vereinigung des Deckels mit der Tür.

5. Ladevorrichtung gemäß Anspruch 1, welche ferner ein Antriebsgerät aufweist, um zu bewirken, dass ein auf der Bühne befestigter Behälter nahe an die Tür gebracht wird.

6. Vorrichtung mit der Ladevorrichtung gemäß Anspruch 1 und einem Behälter (102, 402) zur Aufnahme eines staubfreien Gegenstandes und zum Transport dieses staubfreien Gegenstandes, wobei der Behälter auf der Ladevorrichtung montiert werden kann, und wobei der Behälter aufweist:
a) eine Öffnung, durch welche der staubfreie Gegenstand zwischen einem Innenraum des Behälters und dem Hochreinheitsraum transportiert werden kann;
b) einen Deckel (406), welcher ermöglicht, die Öffnung abzudecken, und welcher dafür ausgebildet ist, mit der Tür (104) der Ladevorrichtung vereinigt und innerhalb der Ladevorrichtung bewegt zu werden, um den Öffnungsbereich zu öffnen und zu verschließen;
c) Befestigungsvorrichtungen, um den Deckel an der Öffnung zu befestigen, wenn der staubfreie Gegenstand in dem Behälter aufgenommen ist und transportiert wird.

7. Vorrichtung gemäß Anspruch 6, wobei ein Winkel, der gebildet ist von einer nach außen verlaufenden Senkrechten auf einer Fläche, auf der die Öffnung in engen Kontakt mit dem Deckel gebracht wird, und einer absteigenden Richtung des mit der Tür der Ladevorrichtung vereinigten und vertikal innerhalb der Ladevorrichtung bewegten Deckels, ein spitzer Winkel ist.

8. Vorrichtung gemäß Anspruch 6, welche ferner ein Dichtungsmaterial zum Schließen eines Spaltes zwischen dem Deckel einerseits und der Öffnung andererseits aufweist.

9. Vorrichtung gemäß Anspruch 6, welche ferner Positionierungsvorrichtungen zur Positionierung des Behälters bezüglich der Ladevorrichtung aufweist, wenn der Behälter auf der Ladevorrichtung montiert wird.

10. Vorrichtung gemäß Anspruch 6, welche ferner einen Griff zum Halten des Behälters aufweist, wenn der Behälter transportiert wird.

11. Vorrichtung gemäß Anspruch 6, welche ferner einen Vorsprung aufweist, der an einem Außenbereich des Deckels ausgebildet ist, und der ein Loch aufweist, in welches ein Stift eingeführt werden kann, um den Deckel und die Tür der Ladevorrichtung miteinander zu vereinigen.

12. Verfahren zum Transport eines staubfreien Gegenstandes unter Einsatz der Vorrichtung gemäß Anspruch 6, welches die folgenden Schritte umfasst:
a) Anordnung des den staubfreien Gegenstand aufnehmenden Behälters auf der an der Ladevorrichtung angeordneten Bühne;
b) Bewirken, dass der Behälter in die Nähe der Tür der Ladevorrichtung gebracht wird;
c) Vereinigung des Deckels des Behälters mit der Tür der Ladevorrichtung;
d) gleichzeitiges Bewegen des so mit der Tür vereinigten Deckels innerhalb der Ladevorrichtung, um die Öffnung der Ladevorrichtung und den Behälter gleichzeitig zu öffnen; und
e) Überführung des in dem Behälter aufgenommenen, staubfreien Gegenstandes von dem Innenraum des Behälters in den Hochreinheitsraum durch den Öffnungsbereich der Ladevorrichtung.

13. Verfahren zum Transport eines staubfreien Gegenstandes gemäß Anspruch 12, welches ferner die Schritte aufweist:
a1) Befestigen des auf der Bühne angeordneten Behälters an dieser Bühne, um den Behälter und die Bühne in Schritt a) miteinander zu vereinigen; und
b1) Bewegen der Bühne durch ein in der Ladevorrichtung vorhandenes Antriebsgerät, um zu bewirken, dass der Behälter in Schritt b) in die Nähe der Tür der Ladevorrichtung gebracht wird.

14. Verfahren zum Transport eines staubfreien Gegenstandes gemäß Anspruch 12, wobei eine Richtung des mit der Tür der Ladevorrichtung vereinigten und innerhalb der Ladevorrichtung bewegten Deckels vertikal ist.

## Revendications

1. Chargeur destiné au transport d'un article sans poussière, dans lequel le chargeur est disposé dans une chambre à faible pureté dans une région limite entre la chambre à faible pureté et une chambre à haute pureté ayant une pression plus élevée que la chambre à faible pureté, le chargeur comprenant :
a) une plateforme mobile (107) positionnée dans la chambre à faible pureté pour monter un récipient (102, 402) de sorte que le récipient entier reste dans la chambre à faible pureté, et un couvercle (103, 406) qu'on peut enlever d'un corps principal du récipient lequel est positionné de sorte qu'il fait face à la chambre à haute pureté, la plateforme mobile étant déplaçable horizontalement par rapport à une paroi (105) qui sépare la chambre à faible pureté de la chambre à haute pureté ;
b) une partie d'ouverture (605) dans la paroi (105) à travers laquelle on peut transporter un article sans poussière entre un intérieur du récipient et la chambre à haute pureté ;
c) une porte (104) pour ouvrir la partie d'ouverture ;
d) un moyen de réunion pour réunir le couvercle du récipient et la porte dans la chambre à faible pureté ;
e) un dispositif d'entraînement (106) positionné dans la chambre à faible pureté pour déplacer le couvercle et la porte ensemble à l'intérieur du chargeur de sorte qu'on peut ouvrir la partie d'ouverture et le récipient simultanément, et **caractérisé en ce qu'**
f) une fente est prévue entre la partie d'ouverture et la porte, à travers laquelle de l'air passe de la chambre à haute pureté à la chambre à faible pureté pour empêcher la poussière d'arriver dans la chambre à haute pureté.

2. Chargeur destiné au transport d'un article sans poussière selon la revendication 1, dans lequel une direction du dit couvercle réuni à la porte du dit chargeur et déplacé à l'intérieur du dit chargeur est verticale.

3. Chargeur destiné au transport d'un article sans poussière selon la revendication 1, dans lequel le dit chargeur comprend en outre une partie d'entraînement pour faire approcher un récipient monté sur la dite plateforme de la porte.

4. Chargeur selon la revendication 1, dans lequel le moyen de réunion pour réunir le dit couvercle et la dite porte comprend :
a) une cheville pour être insérée dans un trou formé dans une saillie ménagée du côté extérieur du dit couvercle ;
b) une autre cheville pour être insérée dans un autre trou formé dans la dite porte ; et
c) un dispositif d'entraînement pour déplacer et la cheville et la dite autre cheville simultanément pour réunir le dit couvercle et la dite porte.

5. Chargeur selon la revendication 1 qui comprend en outre un dispositif d'entraînement pour faire approcher un récipient monté sur la dite plateforme de la porte.

6. Dispositif comprenant le chargeur selon la revendication 1 et un récipient (102, 402) pour y recevoir un article sans poussière et transporter le dit article sans poussière, le dit récipient étant susceptible d'être monté sur le chargeur, le récipient comprenant :
a) une ouverture à travers laquelle on peut transporter l'article sans poussière entre un intérieur du dit récipient et la chambre à haute pureté ;
b) un couvercle (406) qui permet de couvrir la dite ouverture et qui est configuré pour être réuni à la porte (104) du chargeur et pour être déplacé à l'intérieur du dit chargeur pour ouvrir et fermer la dite partie d'ouverture ;
c) des moyens de fixation pour fixer le dit couvercle à la dite ouverture quand l'article sans poussière est reçu dans le dit récipient et transporté.

7. Dispositif selon la revendication 6, dans lequel un angle formé par une perpendiculaire qui s'étend vers l'extérieur sur une surface sur laquelle la dite ouverture est mise en contact étroit avec le dit couvercle et une direction descendante du couvercle réuni à la porte du dit chargeur et déplacé verticalement à l'intérieur du dit chargeur est un angle aigu.

8. Dispositif selon la revendication 6 qui comprend en outre une matière d'étanchéité pour fermer une fente entre le dit couvercle et la dite ouverture.

9. Dispositif selon la revendication 6 qui comprend en outre des moyens de positionnement pour positionner le dit récipient par rapport au chargeur quand le récipient est monté sur le dit chargeur.

10. Dispositif selon la revendication 6 qui comprend en outre une manche pour tenir le récipient quand le dit récipient est transporté.

11. Dispositif selon la revendication 6 qui comprend en outre une saillie formée dans une partie extérieure du dit couvercle laquelle comprend un trou dans lequel peut être inséré une cheville pour réunir le dit couvercle et la porte du dit chargeur.

12. Procédé de transport d'un article sans poussière en utilisant le dispositif selon la revendication 6, qui comprend les étapes de :
a) monter le récipient recevant l'article sans poussière sur la plateforme disposée sur le dit chargeur ;
b) faire approcher le dit récipient de la porte du dit chargeur ;
c) réunir le couvercle du dit récipient à la porte du dit chargeur ;
d) déplacer simultanément le couvercle et la porte ainsi réunis à l'intérieur du chargeur pour ouvrir l'ouverture du dit chargeur et le récipient simultanément ; et
e) transférer le dit article sans poussière reçu dans le récipient d'un intérieur du dit récipient à la chambre à haute pureté à travers la partie d'ouverture du dit chargeur.

13. Procédé de transport d'un article sans poussière selon la revendication 12, qui comprend en outre les étapes de :
a1) fixer le récipient monté sur la dite plateforme à cette plateforme pour réunir le dit récipient et la dite plateforme dans l'étape a) ; et
b1) déplacer la dite plateforme par un appareil d'entraînement présent dans le dit chargeur pour faire approcher le dit récipient de la porte du dit chargeur dans l'étape b).

14. Procédé de transport d'un article sans poussière selon la revendication 12, dans lequel une direction du dit couvercle réuni à la porte du dit chargeur et déplacé à l'intérieur du dit chargeur est verticale.
